# EUROPÄISCHE PATENTSCHRIFT

(11) **EP 2 316 158 B1**
(45) Veröffentlichungstag und Bekanntmachung des Hinweises auf die Patenterteilung: **18.01.2017**
(21) Anmeldenummer: 09777924.3
(22) Anmeldetag: 17.08.2009
(51) Int. Cl.: H02N 1/00, H02N 2/18, H02K 35/00, H01L 41/113, H03H 9/17, H03H 9/24

(54) **MECHANISCHER RESONATOR**
MECHANICAL RESONATOR
RÉSONATEUR MÉCANIQUE

(30) Priorität: 18.08.2008 DE 102008038291
(43) Veröffentlichungstag der Anmeldung: 04.05.2011
(73) Patentinhaber: Albert-Ludwigs-Universität Freiburg, 79098 Freiburg (DE); Hahn-Schickard-Gesellschaft für angewandte Forschung e.V., 78052 Villingen-Schwenningen (DE)
(72) Erfinder: SCHOCK, Wolfram, 72768 Rommelsbach (DE); PETERS, Christian, 79100 Freiburg (DE); MAURATH, Dominic, 79100 Freiburg (DE); MANOLI, Yiannos, 79104 Freiburg (DE); SPREEMANN, Dirk, 79244 Münstertal (DE)
(74) Vertreter: Huwer, Andreas
(86) Internationale Anmeldenummer: PCT/EP2009/005953
(87) Internationale Veröffentlichungsnummer: WO 2010/020388

(56) Entgegenhaltungen:
- EP-A2- 1 317 056
- GB-A- 2 425 160
- US-A1- 2008 074 002

## Beschreibung

Die Erfindung betrifft einen mechanischen Resonator nach dem Oberbegriff von Anspruch 1.

Eine derartige Vorrichtung ist aus GB 2 425 160 A bekannt. Der Resonator der Vorrichtung hat als Resonanzelement ein Feder-Massesystem. Das eine Ende der Feder ist an einer Halterung eingespannt und das andere Ende ist mit einer relativ zu der Halterung auslenkbaren Inertialmasse verbunden. Die Resonanzfrequenz des Feder-Massesystem ist mittels eines Stellglieds einstellbar. Das Stellglied weist ein Piezoelement auf, das derart mit der Feder verbunden ist, dass durch Anlegen einer elektrischen Spannung an die Elektroden des Piezoelements die Federkonstante der Feder veränderbar ist. Die Halterung ist einer Anregungsschwingung ausgesetzt, die über die Halterung auf das Feder-Massesystem einwirkt und die Inertialmasse relativ zu der Halterung auslenkt. Der Resonator ist zur Erzeugung von elektrischer Energie mit einem elektrischen Generator gekoppelt. Zur Messung der vom Generator abgegebenen elektrischen Leistung ist am Generator ein Leistungsmesser angeschlossen. Dieser ist mit einer Ansteuereinrichtung für das Stellglied verbunden. Mit Hilfe der Ansteuereinrichtung wird die Resonanzfrequenz des Feder-Massesystem solange verstellt, bis die gemessene Ausgangsleistung ein Maximum aufweist. Das Piezoelement ermöglicht jedoch nur in einem relativ schmalen Frequenzbereich eine Anpassung der Resonanzfrequenz an die Anregungsschwingung. Liegt die Anregungsschwingung außerhalb dieses Frequenzbereichs, kann die mechanische Energie nicht optimal in elektrische Energie umgewandelt werden.

Aus Dokument US 2008/0074002 A1ist ferner ein Generator bekannt, der einen mechanischen Resonator mit einem elastisch verformbaren, als Tragbalken ausgestalteten Biegekörper aufweist, der an einer Befestigungsstelle an einer Halterung eingespannt ist und eine von der Befestigungsstelle beabstandete, relativ zu dieser durch elastische Biegeverformung des Biegekörpers auslenkbare Auslenkstelle aufweist. Zum Erzeugen von elektrischer Energie weist der Generator zwei zu einem Schichtstapel miteinander verbundene piezoelektrische Schichten auf, die derart in den Kragbalken integriert sind, dass beim Auslenken der Auslenkstelle des Kragbalkens mechanische Spannungen in den piezoelektrischen Schichten erzeugt werden, die zu Ladungsverschiebungen führen, die in Form einer elektrischen Spannung an mit den piezoelektrischen Schichten verbundenen Elektroden abgreifbar sind. Bei Auftreten von mechanischen Schwingungen an dem Kragbalken erzeugen die piezoelektrischen Schichten an den Elektroden eine Wechselspannung, die gleichgerichtet und zum Laden einer Batterie verwendet wird. Der mechanische Resonator hat eine feste Resonanzfrequenz, die an die mechanischen Schwingungen angepasst ist.

Aus EP 1 317 056 A2 ist ferner ein Generator bekannt, der einen mechanischen Resonator mit einem elastisch verformbaren, als Kragbalken ausgestalteten Biegekörper aufweist, der an einer Befestigungsstelle an einer Halterung befestigt ist und an seinem von der Halterung entfernten Ende eine von der Befestigungsstelle beabstandete, relativ zu dieser durch elastische Biegeverformung des Biegekörpers auslenkbare Auslenkstelle aufweist. An der Auslenkstelle ist an dem Biegekörper ein Kästchen angebracht, in dem eine Kugel zwischen zwei Piezoelementen hin- und her bewegbar ist. Beim Auftreten von Schwingungen an der Halterung schwenkt bzw. kippt das Kästchen hin- und her, wobei die Kugel gegen die Piezoelemente rollt. Die dabei in den Piezoelementen auftretenden mechanischen Spannungen verursachen Ladungsverschiebungen, die in Form einer elektrischen Spannung an mit den Piezoelementen verbundenen Elektroden abgreifbar sind. Auch dieser mechanische Resonator weist eine feste Resonanzfrequenz auf

Es besteht deshalb die Aufgabe, einen Resonator der eingangs genannten Art zu schaffen, dessen Resonanzfrequenz in einem relativ breiten Frequenzbereich einstellbar ist.

Diese Aufgabe wird mit den Merkmalen des Anspruchs 1 gelöst.

Durch die Anregungsschwingung werden die Biegekörperabschnitte dazu angeregt, um die Schwenkachse relativ zueinander zu verschwenken. Durch Verstellen des mindestens einen Aktors kann die Geometrie wenigstens eines der Biegekörperabschnitte derart verändert werden, dass der elastische Werkstoff des Biegkörpers beim Verschwenken der Biegekörperabschnitte relativ zueinander verspannt wird und ein Rückstellmoment aufbringt, das der Schwenkbewegung entgegenwirkt bzw. diese unterstützt. Dabei ist das Rückstellmoment von der durch den Aktor an mindestens einem der Biegekörperabschnitte bewirkten Biegeverformung abhängig. In vorteilhafter Weise lässt sich dadurch der Quotient zwischen Rückstellkraft und Schwenkwinkel, also die Federkonstante des Biegekörpers, in einem weiten Bereich einstellen.

Die Biegekörperabschnitte sind als flächige, vorzugsweise plattenförmige Elemente ausgestaltet und die Schwenkachse ist im Wesentlichen in einer von mindestens einem der plattenförmigen Elementen aufgespannten Ebene oder parallel dazu angeordnet. Die Federkonstante, die der Biegekörper bezüglich der Schwenkachse aufweist, kann dadurch in einem großen Bereich verstellt werden.

Zweckmäßigerweise ist die Schwenklagerung als Festkörpergelenk ausgestaltet, das mindestens zwei um die Schwenkachse relativ zueinander verschwenkbare Lagerteile aufweist, die einstückig miteinander verbunden sind. Dabei kann das Festkörpergelenk beispielsweise im Bereich der Schwenkachse eine kleinere Wandstärke aufweisen als die Wandstärke der Biegekörperabschnitte und/oder das Festkörpergelenk kann aus einem biegeweicheren Werkstoff bestehen als das die Biegekörperabschnitte. Gegebenenfalls ist es sogar möglich, dass das Festkörpergelenk einstückig mit den durch dieses miteinander verbundenen Biegekörperabschnitten ausgestaltet ist.

Bei einer bevorzugten Ausgestaltung der Erfindung weist die Schwenklagerung mindestens drei auf der Schwenkachse oder benachbart dazu angeordnete Gelenke auf, die in Richtung der Schwenkachse voneinander beabstandet sind. Die zwischen den Gelenken befindlichen Teilbereiche der Biegekörperabschnitte können sich dann leichter verformen, so dass sich die Federkonstante, die der Biegekörper bezüglich der Schwenkachse aufweist, entsprechend reduziert.

Vorteilhaft ist, wenn ein erstes Gelenk etwa mittig zwischen einem zweiten Gelenk und einem dritten Gelenk angeordnet ist, und wenn die Befestigungsstelle vorzugsweise in Höhe des ersten Gelenks angeordnet ist. Dadurch wird sich eine weitgehend symmetrische Ausgestaltung des Biegekörpers ermöglicht.

Bei einer vorteilhaften Ausführungsform der Erfindung weisen die einzelnen Gelenke jeweils zwei um eine Gelenkstelle relativ zueinander verschwenkbare Gelenkteile auf, von denen ein erstes Gelenkteil mit einem ersten Biegekörperabschnitt und ein zweites Gelenkteil mit einem zweiten Biegekörperabschnitt verbunden ist, wobei in einer Ruhelage, in welcher der Aktor keine Biegekraft in den Biegekörper einleitet, die Gelenkstelle eines ersten Gelenkteils von einer die Gelenkstelle eines zweiten Gelenkteils mit der Gelenkstelle eines dritten Gelenkteils verbindenden geraden Linie beabstandet ist. Die Biegekörperabschnitte sind also in der Ruhelage vorgespannt. Dadurch kann ein eventuell vorhandenes Lagerspiel kompensiert werden.

Vorteilhaft ist, wenn die flächigen Biegekörperabschnitte jeweils in der von ihnen aufgespannten Ebene in Richtung der Schwenkachse eine größere Abmessung aufweisen als in Richtung der Biegeachse. Beim Verbiegen mindestens eines der Biegekörperabschnitte um die Biegeachse ergibt sich dann bezüglich einer Relatiwerschwenkung der Biegekörperabschnitte um die Schwenkachse eine besonders große Versteifung des Biegekörpers.

Bei einer bevorzugten Ausgestaltung der Erfindung weist der mindestens eine Aktor ein mit einer Ansteuereinrichtung elektrisch verbundenes Piezoelement auf. Der Aktor kann dann durch Anlegen einer elektrischen Spannung auf einfache Weise angesteuert bzw. in seiner Länge verstellt werden. Der Resonator kann aber auch einen nach einem anderen Prinzip arbeitenden Aktor aufweisen. So ist es beispielsweise denkbar, bei einem miniaturisierten Resonator einen elektrostatisch verstellbaren Aktor vorzusehen.

Bei einer Weiterbildung der Erfindung ist dem Resonator ein elektrischer Generator zugeordnet, der mit der Auslenkstelle des Biegekörpers in Antriebsverbindung steht. Die aus dem Resonator und dem Generator bestehende Anordnung kann dann dazu verwendet werden, um eine mechanische Anregungsschwingung in elektrische Energie umzuwandeln.

Der Generator kann mindestens eine Tauchspule, mindestens einen Piezokristall, der zur Erzeugung einer von der Auslenkung der Auslenkstelle abhängigen piezoelektrischen Spannung angeordnet ist, und/oder mindestens einen Kondensator mit in Abhängigkeit von der Auslenkung der Auslenkstelle aufeinanderzu- und voneinander wegbewegbaren Elektroden aufweisen. Der Generator ermöglicht dann einen einfache und kostengünstigen Aufbau sowie kompakte Abmessungen.

Nachfolgend sind Ausführungsbeispiele der Erfindung anhand der Zeichnung näher erläutert. Es zeigt
- Fig. 1: ein erstes Ausführungsbeispiel eines Resonators, der einen Biegekörper mit zwei relativ zueinander verschwenkbaren, flächigen Biegekörperabschnitten aufweist, wobei die Biegekörperabschnitte in einer gemeinsamen Ebene angeordnet sind,
- Fig. 2: eine Teilansicht des Resonators, die einen an einer Halterung eingespannten Biegekörperabschnitt zeigt, der sich in Ruhelage in einer Ebene erstreckt,
- Fig. 3: eine Darstellung ähnlich Fig. 2, wobei jedoch der Biegekörperabschnitt derart verformt ist, dass er einen von der Ebene abweichenden Verlauf aufweist, und
- Fig. 4: ein zweites Ausführungsbeispiel eines Resonators, bei dem die Schwenklagerung drei Lagerteile hat, deren Schwenkachsen nicht auf einer geraden Linie liegen, wenn die Biegekörperabschnitte in einer gemeinsamen Ebene angeordnet sind.

Ein mechanischer Resonator 1 weist als Resonanzelement einen Biegekörper 2 auf, der aus einem biegeelastischen Werkstoff besteht und ein mechanisch gedämpftes Feder-Massesystem bildet.

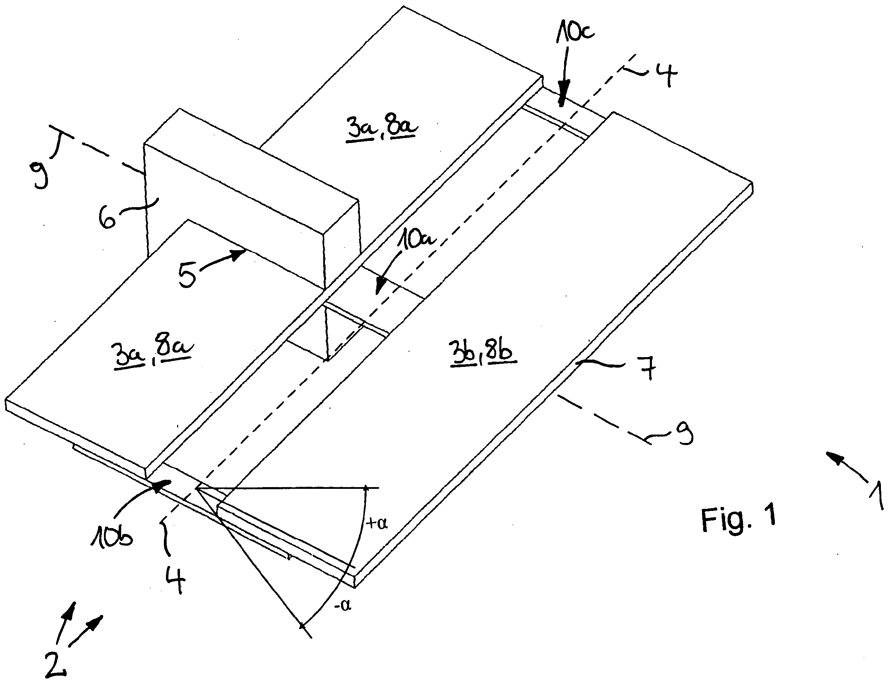

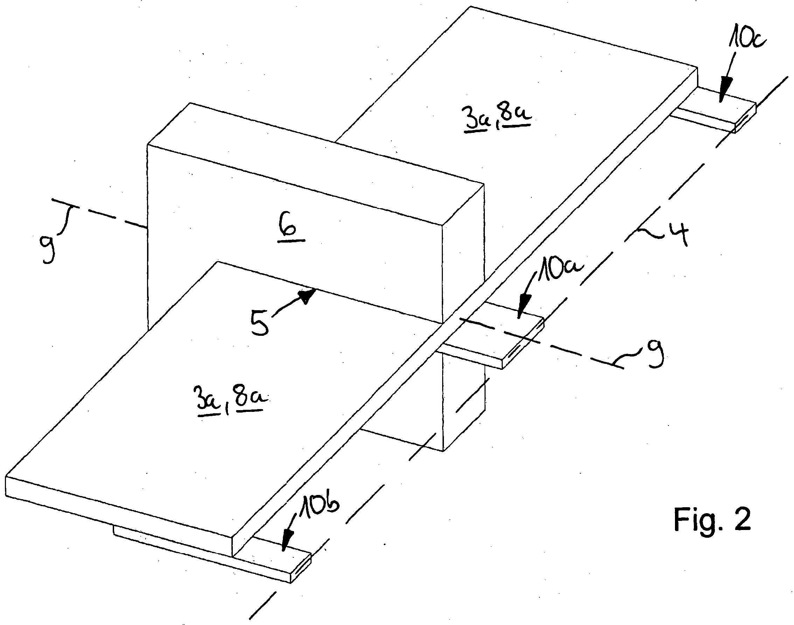

In Fig. 1 ist erkennbar, dass der Biegekörper 2 zwei flächige, etwa plattenförmige Biegekörperabschnitte 3a, 3b hat, die in Ruhelage in gerader Verlängerung nebeneinander angeordnet sind und an ihren einander zugewandten Rändern mittels einer Schwenklagerung um eine Schwenkachse 4 in beide Richtungen verschwenkbar miteinander verbunden sind. Der entsprechende Schwenkwinkel ist in Fig. 1 mit α bezeichnet. Wie sich aus Fig. 1 und 2 ergibt, ist die Schwenkachse 4 etwa parallel zu einer von den plattenförmigen Elementen aufgespannten Ebene angeordnet.

Ein erster Biegekörperabschnitt 3a ist an einer Befestigungsstelle 5 an einer Halterung 6 eingespannt, die derart mit einer in der Zeichnung nicht näher dargestellten mechanischen Anregungsquelle gekoppelt ist, dass eine von der Anregungsquelle erzeugte Anregungsschwingung auf die Halterung 6 übertragen wird. Ein zweiter Biegekörperabschnitt 3b ist an einer Schwenkachse 4 beabstandeten Auslenkstelle 7 relativ zu der Befestigungsstelle 5 auslenkbar.

Zur Biegeversteifung des Biegekörpers 2 hat der Resonator 1 ein Stellglied, das zwei Piezoelemente 8a, 8b umfasst, deren Elektroden jeweils mit Ausgangsanschlüssen einer elektrischen Ansteuereinrichtung verbunden sind. Mit Hilfe der Ansteuereinrichtung kann eine elektrische Spannung an die Elektroden der Piezoelemente 8a, 8b angelegt werden, um deren Länge zu verstellen.

Mit jedem Biegekörperabschnitt 3a, 3b ist jeweils eines der Piezoelemente 7a, 7b derart verbunden, dass sich die Biegekörperabschnitte 3a, 3b beim Anlegen der Spannung an die Elektroden der Piezoelemente 8a, 8b jeweils um eine Biegeachse 9 elastisch verbiegen. Wie in Fig. 2 erkennbar ist, verläuft die Biegeachse 9 etwa orthogonal zur Schwenkachse 4. Beim Anlegen der Spannung an die Elektroden der Piezoelemente 8a, 8b verbiegen sich die beiden Biegekörperdbschnitte 3a, 3b in dieselbe Richtung. Es ist aber auch denkbar, dass die beiden Piezoelemente 8a, 8b unterschiedlich angeordnet sind, so dass sich die Biegekörperabschnitte 3a, 3b beim Anlegen der Spannung in zueinander entgegen gesetzte Richtungen verbiegen.

Die Schwenklagerung weist drei auf der Schwenkachse 4 angeordnete Gelenke 10a, 10b, 10c auf, die in Richtung der Schwenkachse 4 voneinander beabstandet sind. Die Gelenke 10a, 10b, 10c sind jeweils als Festkörpergelenk ausgestaltet; das zwei um die Schwenkachse 4 relativ zueinander verschwenkbare Lagerteile aufweist, die einstückig miteinander verbunden sind. Ein erstes Lagerteil ist jeweils mit einem ersten Biegekörperabschnitt 3a und ein zweites Lagerteil mit einem zweiten Biegekörperabschnitt 3b verbunden, beispielsweise durch eine Schweiß-, Löt- oder Klebestelle.

In Fig. 1 ist erkennbar, dass ein erstes Gelenk 10a etwa mittig zwischen einem zweiten Gelenk 10b und einem dritten Gelenk 10c angeordnet ist. Das zweite Gelenk 10b ist benachbart zu einem ersten Ende des Biegekörpers 2 und das dritte Gelenk 10c benachbart zu dem diesem Ende gegenüberliegenden zweiten Ende des Biegekörpers 2 angeordnet. Außerdem ist in Fig. 1 erkennbar, dass zwischen den Biegekörperabschnitten 3a, 3b ein Bewegungsfreiraum gebildet, durch den die Biegekörperabschnitte 3a, 3b quer zur Schwenkachse 4 voneinander beabstandet sind.

Die Befestigungsstelle 5 ist in Richtung der Schwenkachse 4 etwa mittig am ersten Biegekörperabschnitt 3a angeordnet. Der zweite Biegekörperabschnitt 3b ist nicht an der Halterung 6 eingespannt.

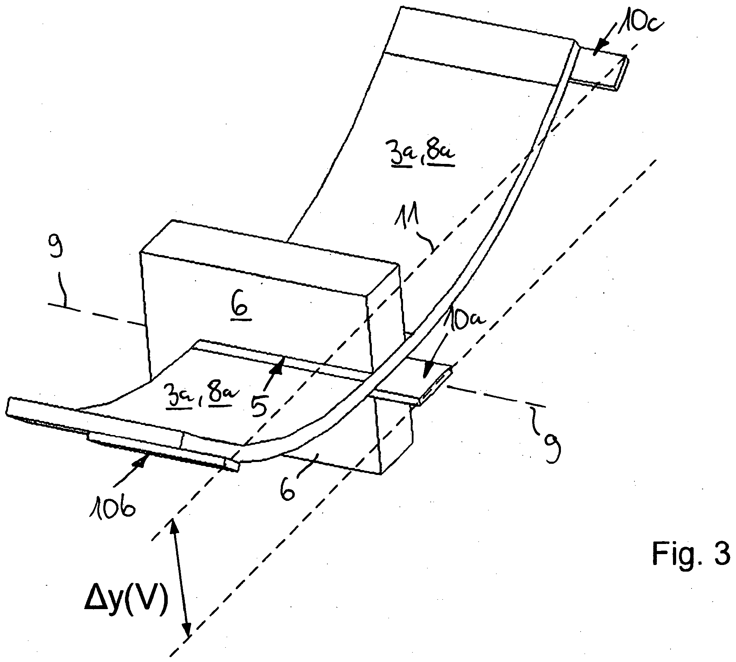

In Fig. 3 ist erkennbar, dass eine vom zweiten Gelenk 10b zum dritten Gelenk 10c verlaufende gerade Verbindungslinie 11 durch einen Abstand Δy von der Schwenkachse 4 des ersten Gelenks 10a beabstandet ist, wenn die Biegekörperabschnitte 3a, 3b derart biegeverformt sind, dass sie einen von einer Ebene abweichenden, gekrümmten Verlauf aufweisen. Dabei ist der Abstand Δy von der an den Elektroden der Piezoelemente 8a, 8b anliegenden Spannung abhängig. Die Gelenkachsen der drei Gelenke 10a, 10b, 10c sind dann nicht in gerader Verlängerung zueinander angeordnet, so dass bei einer Relatiwerschwenkung der Biegekörperabschnitte 3a, 3b um die Schwenkachse 4 Zug- und/oder Druckkräfte zwischen den Lagerteilen der Gelenke 10a, 10b, 10c auftreten. Diese Kräfte werden von den Lagerteilen auf die Biegekörperabschnitte 3a, 3b übertragen und verformen diese elastisch. Dadurch vergrößert sich die Rückstellkraft, die der Werkstoff des Biegekörpers 2 beim Relatiwerschwenken der Biegekörperabschnitte 3a, 3b um die Schwenkachse 4 aus einer Ruhelage aufbaut. Die Federkonstante beim Verschwenken der Biegekörperabschnitte 3a, 3b nimmt also mit zunehmender Verformung oder Krümmung der Biegekörperabschnitte 3a, 3b um die Biegeachse zu.

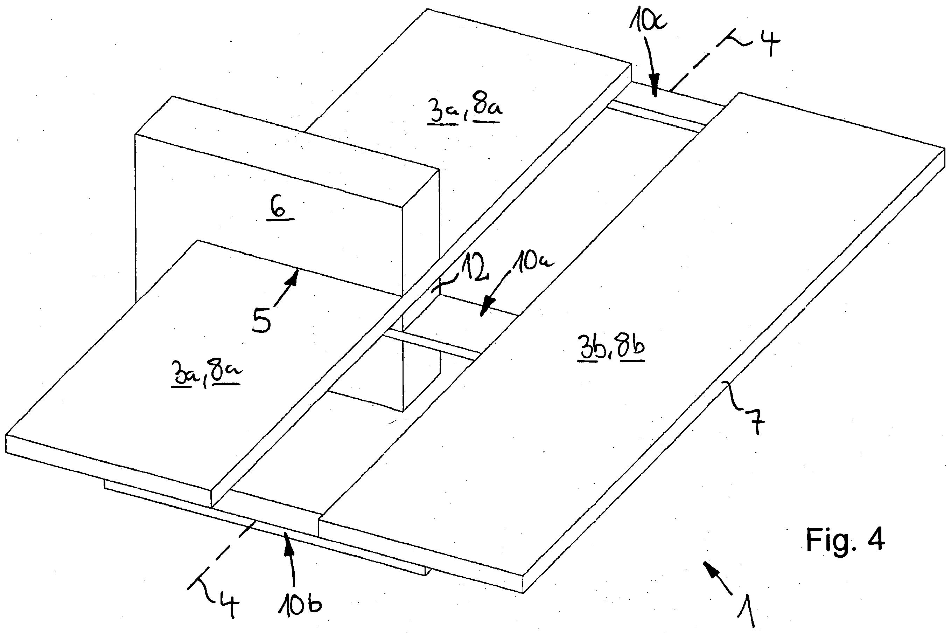

Bei dem in Fig. 4 gezeigten Ausführungsbeispiel ist zwischen den Lagerteilen des ersten Gelenks 10a und den Biegekörperabschnitten 3a, 3b jeweils ein Distanzstück 12 angeordnet. An den Lagerteilen des zweiten Gelenks 10b und des dritten Gelenk 10c sind dagegen keine Distanzstücke vorgesehen. Vielmehr sind diese Lagerteile direkt mit den Biegekörperabschnitten 3a, 3b verbunden. In einer Ruhelage, in der die Biegekörperabschnitte 3a, 3b in derselben Ebene bzw. in gerader Verlängerung zueinander angeordnet sind und in der die Piezoelemente 8a, 8b keine Biegekräfte in die Biegekörper einleiten, ist also die Gelenkachse des ersten Gelenks 10a von einer die Gelenkachse des zweiten Gelenks 10b mit der Gelenkachse des dritten Gelenks 10c verbindenden geraden Linie beabstandet.

Dadurch tritt bei einer Relatiwerschwenkung der Biegekörperabschnitte 3a, 3b um die Schwenkachse 4 zwischen den Biegekörperabschnitten 3a, 3b auch dann eine Rückstellkraft auf, wenn an den Elektroden der Piezoelemente 8a, 8b keine elektrische Spannung anliegt. Die Größe der Rückstellkraft ist davon abhängig, in welche Richtung die Biegekörperabschnitte 3a, 3b mit Hilfe der Piezoelemente 8a, 8b gekrümmt werden. Werden die Biegekörperabschnitte 3a, 3b mit ihren von der Halterung 6 entfernten Enden aus der in Fig. 4 dargestellten Ruhelage nach unten ausgelenkt, reduziert sich die Rückstellkraft bei konstantem Schwenkwinkel a. Werden die freien Enden Biegekörperabschnitte 3a, 3b aus der Ruhelage nach oben ausgelenkt, erhöht sich die Rückstellkraft bei konstantem Schwenkwinkel a.

## Patentansprüche

1. Mechanischer Resonator (1) mit einem elastisch verformbaren Biegekörper (2), der an einer Befestigungsstelle (5) mit einer Halterung (6) verbundenen ist und eine von der Befestigungsstelle (5) beabstandete, relativ zu dieser durch elastische Biegeverformung des Biegekörpers (2) auslenkbare Auslenkstelle (7) aufweist, und mit mindestens einem Aktor, der wenigstens zwei relativ zueinander verstellbare Aktorstellen hat, die derart mit dem Biegekörper (2) verbunden sind, dass dieser durch Betätigen des Aktors um eine Biegeachse (9) elastisch biegbar ist, **dadurch gekennzeichnet, dass** der Biegekörper (2) mindestens zwei als flächige Elemente ausgestaltete Biegekörperabschnitte (3a, 3b) hat, die mittels einer Schwenklagerung um eine zwischen der Befesfigungsstelle (5) und der Auslenkstelle (7) angeordnete, im Wesentlichen in einer von mindestens einem der Biegekörperabschnitte (3a, 3b) aufgespannten Ebene oder parallel dazu angeordneten Schwenkachse (4) relativ zueinander verschwenkbar miteinander verbunden sind, und dass die Schwenkachse (4) derart quer zur Biegeachse (9) angeordnet ist, dass die Schwenklagerung durch Verschwenken der Biegekörperabschnitte (3a, 3b) relativ zueinander mit von der Biegeverformung abhängigen Zug- und/oder Druckkräften beaufschlagbar ist und der elastische Werkstoff des Biegekörpers (2) zum Aufbringen eines der Schwenkbewegung entgegenwirkenden bzw. diese unterstütztenden Rückstellmoments verspannt wird.

2. Mechanischer Resonator (1) nach Anspruch 1, **dadurch gekennzeichnet, dass** die Schwenkachse (4) etwa rechtwinklig zur Biegeachse (9) angeordnet.

3. Mechanischer Resonator (1) nach Anspruch 1 oder 2, **dadurch gekennzeichnet, dass** die Schwenklagerung als Festkörpergelenk ausgestaltet ist, das mindestens zwei um die Schwenkachse (4) relativ zueinander verschwenkbare Lagerteile aufweist, die einstückig miteinander verbunden sind.

4. Mechanischer Resonator (1) nach einem der Ansprüche 1 bis 3, **dadurch gekennzeichnet, dass** die Schwenklagerung mindestens drei auf der Schwenkachse (4) oder benachbart dazu angeordnete Gelenke (10a, 10b, 10c) aufweist, die in Richtung der Schwenkachse (4) voneinander beabstandet sind.

5. Mechanischer Resonator (1) nach einem der Ansprüche 1 bis 4, **dadurch gekennzeichnet, dass** ein erstes Gelenk (10a) etwa mittig zwischen einem zweiten Gelenk (10b) und einem dritten Gelenk (10c) angeordnet ist, und dass die Befestigungsstelle (5) vorzugsweise in Höhe des ersten Gelenks (10a) angeordnet ist.

6. Mechanischer Resonator (1) nach einem der Ansprüche 1 bis 5, **dadurch gekennzeichnet, dass** die einzelnen Gelenke (10a, 10b, 10c) jeweils zwei um eine Gelenkstelle relativ zueinander verschwenkbare Gelenkteile aufweisen, von denen ein erstes Gelenkteil mit einem ersten Biegekörperabschnitt (3a) und ein zweites Gelenkteil mit einem zweiten Biegekörperabschnitt (3b) verbunden ist, und dass in einer Ruhelage, in welcher der Aktor keine Biegekraft in den Biegekörper (2) einleitet, die Gelenkstelle eines ersten Gelenkteils (10a) von einer die Gelenkstelle eines zweiten Gelenkteils (10b) mit der Gelenkstelle eines dritten Gelenkteils (10c) verbindenden geraden Linie beabstandet ist.

7. Mechanischer Resonator (1) nach einem der Ansprüche 2 bis 6, **dadurch gekennzeichnet, dass** die flächigen Biegekörperabschnitte (3a, 3b) jeweils in der von ihnen aufgespannten Ebene in Richtung der Schwenkachse (4) eine größere Abmessung aufweisen als in Richtung der Biegeachse (9).

8. Mechanischer Resonator (1) nach einem der Ansprüche 1 bis 7, **dadurch gekennzeichnet, dass** der mindestens eine Aktor ein mit einer Ansteuereinrichtung elektrisch verbundenes Piezoelement (8a, 8b) aufweist.

9. Mechanischer Resonator (1) nach einem der Ansprüche 1 bis 8, **dadurch gekennzeichnet, dass** dem Resonator (1) ein elektrischer Generator zugeordnet ist, der mit der Auslenkstelle (7) des Biegekörpers (2) in Antriebsverbindung steht.

10. Mechanischer Resonator (1) nach einem der Ansprüche 1 bis 9, **dadurch gekennzeichnet, dass** der Generator mindestens eine Tauchspule, mindestens einen Piezokristall, der zur Erzeugung einer von der Auslenkung der. Auslenkstelle abhängigen piezoelektrischen Spannung angeordnet ist, und/oder mindestens einen Kondensator mit in Abhängigkeit von der Auslenkung der Auslenkstelle aufeinanderzu- und voneinander wegbewegbaren Elektroden aufweist.

## Claims

1. Mechanical resonator (1) comprising an elastically deformable bending body (2) which is connected to a support (6) at a fastening point (5) and has a deflection point (7) which is at a distance from the fastening point (5) and can be deflected relative to the said fastening point by elastic bending deformation of the bending body (2), and comprising at least one actuator which has at least two actuator points which can be adjusted relative to one another and which are connected to the bending body (2) in such a way that the said bending body can be elastically bent about a bending axis (9) by operating the actuator, **characterized in that** the bending body (2) has at least two bending body sections (3a, 3b) which are configured as flat elements and which are connected to one another such that they can pivot relative to one another by means of a pivot bearing about a pivot axis which is arranged between the fastening point (5) and the deflection point (7), substantially in a plane which is spanned by at least one of the bending body sections (3a, 3b) or parallel to the said plane, and **in that** the pivot axis (4) is arranged transverse to the bending axis (9) in such a way that the pivot bearing can be subjected to the action of tensile and/or pressure forces, which are dependent on the bending deformation, by pivoting the bending body sections (3a, 3b) relative to one another, and the elastic material of the bending body (2) is tensioned in order to apply a return moment which counteracts the pivot movement or assists the said pivot movement.

2. Mechanical resonator (1) according to Claim 1, **characterized in that** the pivot axis (4) is arranged approximately at a right angle in relation to the bending axis (9).

3. Mechanical resonator (1) according to Claim 1 or 2, **characterized in that** the pivot bearing is designed as a solid body joint which has at least two bearing parts which can pivot relative to one another about the pivot axis (4) and which are integrally connected to one another.

4. Mechanical resonator (1) according to one of Claims 1 to 3, **characterized in that** the pivot bearing has at least three joints (10a, 10b, 10c) which are arranged on the pivot axis (4) or adjacent to the said pivot axis and which are at a distance from one another in the direction of the pivot axis (4).

5. Mechanical resonator (1) according to one of Claims 1 to 4, **characterized in that** a first joint (10a) is arranged approximately centrally between a second joint (10b) and a third joint (10c), and **in that** the fastening point (5) is preferably arranged level with the first joint (10a).

6. Mechanical resonator (1) according to one of Claims 1 to 5, **characterized in that** the individual joints (10a, 10b, 10c) each have two joint parts which can be pivoted relative to one another about a point of articulation, a first joint part from amongst the said two joint parts being connected to a first bending body section (3a) and a second joint part from amongst the said two joint parts being connected to a second bending body section (3b), and **in that**, in an inoperative position in which the actuator does not introduce any bending force into the bending body (2), the point of articulation of a first joint part (10a) is at a distance from a straight line which connects the point of articulation of a second joint part (10b) to the point of articulation of a third joint part (10c).

7. Mechanical resonator (1) according to one of Claims 2 to 6, **characterized in that** the flat bending body sections (3a, 3b), in the plane which is spanned by them, each have a larger dimension in the direction of the pivot axis (4) than in the direction of the bending axis (9).

8. Mechanical resonator (1) according to one of Claims 1 to 7, **characterized in that** the at least one actuator has a piezo element (8a, 8b) which is electrically connected to a drive device.

9. Mechanical resonator (1) according to one of Claims 1 to 8, **characterized in that** an electrical generator which is drive-connected to the deflection point (7) of the bending body (2) is associated with the resonator (1).

10. Mechanical resonator (1) according to one of Claims 1 to 9, **characterized in that** the generator has at least one plunger coil, at least one piezo crystal which is provided for generating a piezoelectric voltage which is dependent on the deflection of the deflection point, and/or at least one capacitor with electrodes which can move towards one another and away from one another depending on the deflection of the deflection point.

## Revendications

1. Résonateur mécanique (1) comprenant un corps flexible déformable élastiquement (2), qui est connecté au niveau d'un point de fixation (5) à une fixation (6) et qui présente un point de déviation (7) espacé du point de fixation (5), pouvant être dévié par rapport à celui-ci par déformation flexible élastique du corps flexible (2), comprenant au moins un actionneur qui présente au moins deux points d'actionneur déplaçables l'un par rapport à l'autre, lesquels sont connectés au corps flexible (2) de telle sorte que celui-ci puisse être fléchi élastiquement autour d'un axe de réflexion par actionnement de l'actionneur, **caractérisé en ce que** le corps flexible (2) présente au moins deux portions de corps flexible (3a, 3b) configurées sous forme d'éléments plats, qui sont connectées l'une à l'autre de manière à pouvoir pivoter l'une par rapport à l'autre au moyen d'un support sur palier pivotant autour d'un axe de pivotement (4) disposé entre le point de fixation (5) et le point de déviation (7), disposé essentiellement dans un plan tendu par au moins l'une des portions de corps flexible (3a, 3b) ou disposé parallèlement à celui-ci, et **en ce que** l'axe de pivotement (4) est disposé transversalement à l'axe de flexion (9) de telle sorte que le support sur palier pivotant puisse être sollicité par pivotement des portions de corps flexible (3a, 3b) l'une par rapport à l'autre par des forces de traction et/ou de compression dépendant de la déformation élastique et que le matériau élastique du corps flexible (2) soit tendu de manière à appliquer un couple de rappel agissant à l'encontre du mouvement de pivotement ou favorisant celui-ci.

2. Résonateur mécanique (1) selon la revendication 1, **caractérisé en ce que** l'axe de pivotement (4) est disposé approximativement perpendiculairement à l'axe de flexion (9).

3. Résonateur mécanique (1) selon la revendication 1 ou 2, **caractérisé en ce que** le support sur palier pivotant est réalisé sous forme d'articulation à corps solide, qui présente au moins deux pièces de palier pouvant pivoter l'une par rapport à l'autre autour de l'axe de pivotement (4), lesquelles sont connectées d'une seule pièce l'une à l'autre.

4. Résonateur mécanique (1) selon l'une quelconque des revendications 1 à 3, **caractérisé en ce que** le support sur palier pivotant présente au moins trois articulations (10a, 10b, 10c) disposées sur l'axe de pivotement (4) ou à côté de celui-ci, qui sont espacées les unes des autres dans la direction de l'axe de pivotement (4).

5. Résonateur mécanique (1) selon l'une quelconque des revendications 1 à 4, **caractérisé en ce qu'**une première articulation (10a) est disposée approximativement centralement entre une deuxième articulation (10b) et une troisième articulation (10c), et **en ce que** le point de fixation (5) est disposé de préférence à la hauteur de la première articulation (10a).

6. Résonateur mécanique (1) selon l'une quelconque des revendications 1 à 5, **caractérisé en ce que** les articulations individuelles (10a, 10b, 10c) présentent chacune deux pièces d'articulation pouvant pivoter l'une par rapport à l'autre autour d'un point d'articulation, dont une première pièce d'articulation est connectée à une première portion de corps flexible (3a) et une deuxième pièce d'articulation est connectée à une deuxième portion de corps flexible (3b), et **en ce que**, dans une position de repos dans laquelle l'actionneur n'introduit aucune force de flexion dans le corps flexible (2), le point d'articulation d'une première pièce d'articulation (10a) est espacé d'une ligne droite reliant le point d'articulation d'une deuxième pièce d'articulation (10b) au point d'articulation d'une troisième pièce d'articulation (10c).

7. Résonateur mécanique (1) selon l'une quelconque des revendications 2 à 6, **caractérisé en ce que** les portions de corps flexible plates (3a, 3b) présentent chacune dans le plan tendu par celles-ci, dans la direction de l'axe de pivotement (4), une plus grande dimension que dans la direction de l'axe de flexion (9).

8. Résonateur mécanique (1) selon l'une quelconque des revendications 1 à 7, **caractérisé en ce que** l'au moins un actionneur présente un élément piézoélectrique (8a, 8b) connecté électriquement à un dispositif pilote.

9. Résonateur mécanique (1) selon l'une quelconque des revendications 1 à 8, **caractérisé en ce qu'**un générateur électrique est associé au résonateur (1), lequel est en liaison d'entraînement avec le point de déviation (7) du corps flexible (2).

10. Résonateur mécanique (1) selon l'une quelconque des revendications 1 à 9, **caractérisé en ce que** le générateur présente au moins une bobine plongeante, au moins un cristal piézoélectrique, qui est prévu pour générer une tension piézoélectrique dépendant de la déviation du point de déviation et/ou au moins un condensateur avec des électrodes déplaçables l'une vers l'autre et à l'écart l'une de l'autre en fonction de la déviation du point de déviation.
